(19) **Europäisches Patentamt**
**European Patent Office**
**Office européen des brevets**

(11) **EP 2 008 808 A1**

(12) **EUROPEAN PATENT APPLICATION**
published in accordance with Art. 153(4) EPC

(43) Date of publication:
**31.12.2008 Bulletin 2009/01**

(51) Int Cl.:
*B32B 9/00* (2006.01)   *B65D 65/02* (2006.01)
*H01L 51/50* (2006.01)   *H05B 33/04* (2006.01)

(21) Application number: **07741616.2**

(22) Date of filing: **13.04.2007**

(86) International application number:
**PCT/JP2007/058180**

(87) International publication number:
**WO 2007/119825 (25.10.2007 Gazette 2007/43)**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(30) Priority: **14.04.2006 JP 2006112084**

(71) Applicant: **MITSUBISHI PLASTICS, INC.**
**Tokyo 103-0021 (JP)**

(72) Inventors:
• **YOSHIDA, Shigenobu**
**Ushiku-shi**
**Ibaraki 300-1201 (JP)**
• **OKAWARA, Chiharu**
**Ushiku-shi**
**Ibaraki 300-1201 (JP)**
• **HACHISUKA, Tooru**
**Ushiku-shi**
**Ibaraki 300-1201 (JP)**

(74) Representative: **Gille Hrabal Struck Neidlein Prop Roos**
**Patentanwälte**
**Brucknerstrasse 20**
**40593 Düsseldorf (DE)**

(54) **GAS BARRIER LAMINATE**

(57)    There is provided a gas-barrier laminate composed of a base film and an inorganic thin film layer formed on the base film which considerably enhanced in gas-barrier property and gelbo flex resistance. The present invention relates to a gas-barrier laminate comprising a base film containing at least one compound selected from the group consisting of polyvinyl alcohol and an ethylene-vinyl alcohol copolymer, and an anchor coat layer and an inorganic thin film layer successively formed on one surface of the base film in this order, wherein the base film is in the form of a biaxially stretched film having a variation in thickness of 3.5 μm or less and a crystallinity of 30% or more.

EP 2 008 808 A1

**Description**

TECHNICAL FIELD

The present invention relates to gas-barrier laminates.

BACKGROUND ART

Hitherto, gas-barrier films composed of a plastic film as a substrate and an inorganic thin film formed on a surface of the plastic film which is made of silicon oxide, aluminum oxide, magnesium oxide, etc., have been extensively used in packaging applications in which products to be packaged are required to be shielded from various gases such as water vapor and oxygen, for example, for packaging food, industrial products, medicines or drugs, etc., to prevent deterioration thereof.

These gas-barrier films formed therein with such an inorganic thin film have been variously improved for the purpose of preventing deterioration in gas-barrier property thereof or further enhancing the gas-barrier property. For example, there is disclosed a method of forming a silicon oxide thin film layer on one surface of a film made of polyvinyl alcohol (refer to Patent Documents 1 and 2). Also, there is disclosed a method of forming a mixed resin layer made of an isocyanate compound and a saturated polyester between a plastic film made of a polyester, etc., and a silicon oxide thin film layer for the purpose of improving adhesion therebetween (refer to Patent Document 3). Further, there is disclosed a transparent plastic film that is constituted from a stretched film as a laminate obtained by co-extruding a saponified product of an ethylene-vinyl acetate copolymer and a polyamide, and a thin film layer made of silicon oxide, in which a rate of change in dimension and volatility weight loss of the plastic film as well as a thickness of the thin film layer made of silicon oxide, are defined in specific ranges (refer to Patent Document 4).

However, all of these methods described in the above Patent Documents are still unsatisfactory in gas-barrier property and gelbo flex resistance of the obtained films.

Patent Document 1: JP 1-184127A
Patent Document 2: JP 2-258251A
Patent Document 3: JP 3-86539A
Patent Document 4: JP 4-107138A

DISCLOSURE OF THE INVENTION

PROBLEM TO BE SOLVED BY THE INVENTION

In view of the above conventional problems, an object of the present invention is to provide a gas-barrier laminate composed of a base film and an inorganic thin film layer formed on the base film which is considerably improved in gas-barrier property and gelbo flex resistance.

MEANS FOR SOLVING THE PROBLEM

Thus, the present invention relates to:

(1) A gas-barrier laminate comprising a base film containing at least one compound selected from the group consisting of polyvinyl alcohol and an ethylene-vinyl alcohol copolymer, and an anchor coat layer and an inorganic thin film layer successively formed on one surface of the base film in this order, wherein the base film is in the form of a biaxially stretched film having a variation in thickness of 3.5 $\mu$m or less and a crystallinity of 30% or more;
(2) a gas-barrier laminate comprising a base film produced by co-extruding an ethylene-vinyl alcohol copolymer and a polyamide, and an anchor coat layer and an inorganic thin film layer successively formed on one surface of the base film in this order, wherein the base film is in the form of a biaxially stretched film having a variation in thickness of 3.5 $\mu$m or less, and the ethylene-vinyl alcohol copolymer contained in the base film has a crystallinity of 30% or more; and
(3) a process for producing a gas-barrier laminate, comprising the steps of:

(1) forming a base film in the form of a biaxially stretched film having a variation in thickness of 3.5 $\mu$m or less and a crystallinity of 30% or more, from at least one compound selected from the group consisting of polyvinyl alcohol and an ethylene-vinyl alcohol copolymer; and
(2) successively laminating an anchor coat layer and an inorganic thin film layer on one surface of the based film formed in the step (1) in this order.

EFFECT OF THE INVENTION

In accordance with the present invention, the gas-barrier laminate composed of a base film and an inorganic thin film layer formed on the base film can be considerably enhanced in gas-barrier property and gelbo flex resistance.

BEST MODE FOR CARRYING OUT THE INVENTION

The gas-barrier laminate of the present invention is composed of a base film containing at least one compound selected from the group consisting of polyvinyl alcohol and an ethylene-vinyl alcohol copolymer, and an anchor coat layer and an inorganic thin film layer successively formed on one surface of the base film in this order.

[Base Film]

The base film used in the gas-barrier laminate of the present invention is in the form of a biaxially stretched film containing polyvinyl alcohol and/or an ethylene-vinyl alcohol copolymer, and preferably a biaxially stretched film made of polyvinyl alcohol and/or an ethylene-vinyl alcohol copolymer solely or a biaxially stretched film obtained by co-extruding an ethylene-vinyl alcohol copolymer and a polyamide.
The polyvinyl alcohol used for forming the base film is obtained by saponifying a vinyl acetate polymer. From the viewpoint of a good gas-barrier property of the base film, the degree of saponification of the polyvinyl alcohol is preferably 90 mol% or more, more preferably 95 mol% or more and still more preferably 99 mol% or more. The degree of polymerization of the polyvinyl alcohol is usually from about 1000 to about 3000.
On the other hand, the ethylene-vinyl alcohol copolymer is obtained by saponifying an ethylene-vinyl acetate copolymer. From the viewpoints of a good gas-barrier property and a good thermal stability of the resultant base film, the degree of saponification of the ethylene-vinyl acetate copolymer is preferably 90 mol% or more, more preferably 95 mol% or more and still more preferably 99 mol% or more.
Also, the content of ethylene units in the ethylene-vinyl alcohol copolymer is preferably from 25 to 50 mol%, more preferably from 30 to 48 mol% and still more preferably from 32 to 45 mol% from the viewpoints of a good gas-barrier property, a good flexing property and a good fatigue resistance of the resultant base film.
The base film may be made of only either one of polyvinyl alcohol and the ethylene-vinyl alcohol copolymer, but may also be made of combination of polyvinyl alcohol and the ethylene-vinyl alcohol copolymer. In addition, the base film may also be in the form of a laminated film obtained by co-extruding the above polyvinyl alcohol or ethylene-vinyl alcohol copolymer with a polyester-based resin, a polyamide-based resin, etc. In the present invention, from the viewpoints of a good gas-barrier property and a good processability, a single-layer film made of polyvinyl alcohol or the ethylene-vinyl alcohol copolymer only, and a laminated film obtained by co-extruding the ethylene-vinyl alcohol copolymer and a polyamide, are preferably used as the base film.
Examples of the polyamide to be co-extruded together with the ethylene-vinyl alcohol copolymer include a homopolymer of $\varepsilon$-caprolactam, a copolymer of $\varepsilon$-caprolactam as a main component with 2 to 10 mol% of a compound copolymerizable therewith, and a mixture of the above homopolymer and/or copolymer with 5 to 40% by weight of a polymer having a good compatibility therewith. Specific examples of the polyamide containing $\varepsilon$-caprolactam as a main component such as the homopolymer of $\varepsilon$-caprolactam, include nylon-6, nylon-66 and nylon-12. In addition, the above aliphatic polyamide may also be mixed with 0.5 to 10% by weight of an aromatic polyamide to impart a good tearability to the resultant film.
The base film is required to have a variation in thickness of 3.5 $\mu$m or less as measured by a thickness meter. The base film having a variation in thickness of 3.5 $\mu$m or less is sufficiently and uniformly cooled upon depositing an inorganic thin film thereon, resulting in an enhanced gas-barrier property of the resultant film. From the above viewpoint, the variation in thickness of the base film is preferably 2.5 $\mu$m or less, more preferably 2 $\mu$m or less and still more preferably 1.5 $\mu$m or less. In the present invention, although the variation in thickness of the base film is preferably as small as possible, the lower limit of the variation in thickness of the base film is usually 0.05 $\mu$m from the viewpoint of a good processability.
Meanwhile, the variation in thickness of the base film as described in the present invention is defined as the difference between the maximum and minimum values among those thickness values measured at optional points of the base film. According to the present invention, the upper limit of the variation in thickness of the base film is limited to 3.5 $\mu$m. Upon determining the variation in thickness of the base film, it is preferred that the measurement is made at points as many as possible over an entire portion of the base film, and the difference between the maximum and minimum thickness values lies within the above specified range. More specifically, the variation in thickness of the base film may be measured by the following method.

<Method for Measuring Variation in Thickness>

Using a thickness meter, the thickness of a film having a size of at least 10 cm x 10 cm, for example, is measured at respective points spaced apart at intervals of 2 cm in each of the width and flow directions thereof, and the difference between the maximum and minimum thickness values as measured is determined as the variation in thickness of the film. In the present invention, as the method of adjusting the variation in thickness of the film into the above-specified range, there may be used, for example, a method of extruding a raw resin material while controlling a variation in output from an extruder, for example, by reducing the variation in output from the extruder to 5% or less and preferably 1% or less; a method of controlling a surface accuracy of a T-die, for example, to 0.1 s or less, to suitably adjust a thickness of the film in the width direction thereof owing to control of the T-die lip; and a method of controlling stretch ratios in the width and flow directions, for example, controlling the stretch ratios to 2 times or more.

The polyvinyl alcohol or ethylene-vinyl alcohol copolymer forming the base film is required to have a crystallinity of 30% or more. The base film formed from the polyvinyl alcohol or ethylene-vinyl alcohol copolymer having a crystallinity of 30% or more is enhanced in gas-barrier property. From the above viewpoint, the crystallinity of the polyvinyl alcohol or ethylene-vinyl alcohol copolymer is preferably 35% or more and more preferably 40% or more. The upper limit of the crystallinity of the polyvinyl alcohol or ethylene-vinyl alcohol copolymer is not particularly limited, and is usually about 90% from the viewpoint of suitable stretching conditions, and further about 60% from the viewpoint of a good processability. Meanwhile, the crystallinity used in the present invention means the value measured by the following method.

<Method of Measuring Crystallinity>

Using a differential scanning calorimeter, the amount of heat of fusion (J/g) of a film as well as the amount of heat of fusion (J/g) of a crystal of a resin forming the film are measured, and the crystallinity of the film is calculated from these measured values according to the following formula:

$$\text{Crystallinity (\%)} = [(\text{Amount of Heat of Fusion of Film})/(\text{Amount of Heat of Fusion of Crystal})] \times 100.$$

As the method of controlling the crystallinity into the above specified range defined by the present invention, there may be used, for example, a method of controlling stretch ratios of the film, a method of controlling heat-setting temperature and time of the film, etc.

The base film is obtained by subjecting a raw unstretched film to biaxial stretching. The biaxially stretched film used as the base film in the present invention may be produced, for example, by the following method.

First, the above polyvinyl alcohol and/or ethylene-polyvinyl alcohol copolymer are appropriately mixed with various known additives such as ultraviolet absorbers, light stabilizers, antioxidants, antistatic agents, anti-blocking agents, plasticizers, lubricants, fillers, light-shielding agents, colorants and anti-flexing pinhole improvers, and the resultant mixture is melted solely or together with a polyamide, etc., for example, in an extruder, and then extruded or co-extruded through a cyclic die or a T-die, followed by rapidly cooling the extruded or co-extruded film to produce an unstretched film in the form of a substantially amorphous and non-oriented film.

As the method for producing the laminate by co-extrusion, there may be used the conventional co-extrusion lamination method in which the ethylene-vinyl alcohol copolymer (EVOH) and polyamide (ONY) both kept in a molten state are respectively extruded into a laminated film through separate dies or a common die. In this case, examples of a layer structure of the resultant base film include a two-layer structure such as EVOH/ONY, a three-layer structure such as ONY/EVOH/ONY and EVOH/ONY/EVOH, and a five-layer structure such as ONY/adhesive layer/EVOH/adhesive layer/ONY.

Next, the thus obtained unstretched film is subjected to the conventionally known biaxial stretching process such as tenter-type sequential biaxial stretching, tenter-type simultaneous biaxial stretching and tubular-type simultaneous biaxial stretching to stretch the unstretched film in the flow (longitudinal axis) direction and the direction (lateral axis direction) perpendicular to the flow direction, i.e., in the width direction, thereby producing a biaxially stretched film. Upon the biaxial stretching, the stretch ratio in the flow direction is usually from about 2 to about 6 times and preferably from 2.5 to 5 times from the viewpoint of a good strength and a less fluctuation in thickness thereof. Whereas, the stretch ratio in the width direction is usually from about 2 to about 5 times and preferably from 2.5 to 4 times from the same viewpoints. The stretching temperature is preferably from 40 to 120°C and more preferably from 50 to 110 °C from the viewpoint of a good processability.

In the present invention, after completion of the stretching, the resultant stretched film is preferably subjected to heat-setting procedure by heat-treating the film at a temperature not lower than a glass transition point of the film but lower than a melting point thereof in order to enhance the crystallinity and fixing orientation of molecular chains.

The above stretching treatment is preferred to produce a biaxially stretched film having a crystallinity of 30% or more.

The thickness of the thus obtained base film is not particularly limited, and is usually from about 5 to about 500 $\mu$m, preferably from 10 to 200 $\mu$m and more preferably from 10 to 100 $\mu$m from the viewpoints of good mechanical strength, flexibility and transparency thereof.

[Anchor Coat Layer]

In the gas-barrier laminate of the present invention, an anchor coat layer is formed on the surface of the base film on which the below-mentioned inorganic thin film layer is to be subsequently formed. The anchor coat layer is provided in order to eliminate fine irregularities on the surface of the base film and thereby improve a surface smoothness thereof. As a result, the inorganic thin film layer formed on the anchor coat layer is enhanced in denseness and adhesion to the base film, resulting in improved gas-barrier property and gelbo flex resistance of the resultant laminate.

The anchor coat layer may be produced, for example, from an anchor coat agent containing at least one resin selected from the group consisting of polyester-based resins, polyurethane-based resins, polyacrylic resins, isocyanate-based resins, oxazoline-based resins, carbodiimide-based resins and alcoholic hydroxyl group-containing resins, in particular, preferably from such an anchor coat agent containing at least one resin selected from the group consisting of polyester-based resins, polyurethane-based resins, polyacrylic resins, isocyanate-based resins and oxazoline-based resins from the viewpoint of a good gas-barrier property. The anchor coat agent may be of either a solvent type containing an organic solvent, an aqueous solution type or an aqueous emulsion type. Specific examples of the alcoholic hydroxyl group-containing resins include polyvinyl alcohol and an ethylene-vinyl alcohol copolymer.

Among the above anchor coat agents, from the viewpoint of attaining the above properties, there is preferably used a mixture of an isocyanate compound forming the above isocyanate-based resins with a polyester and preferably a saturated polyester. Specific examples of the isocyanate compound used herein include hexamethylene diisocyanate, diphenylmethane diisocyanate, a mixture of 3 mol of hexamethylene diisocyanate and 1 mol of trimethylol propane, triphenylmethane triisocyante, and various other isocyanate compounds.

The mixing mass ratio of the isocyanate compound to the polyester is usually from 80:20 to 30:70 from the viewpoints of a good adhesion of the obtained anchor coat layer to the adjacent layers and a good curling resistance.

The anchor coat agent may be applied by appropriate known coating methods, for example, by any of methods using a reverse roll coater, a gravure coater, a rod coater, an air doctor coater, a sprayer or a brush. The anchor coat agent applied may be dried at a temperature of from about 40 to about 180°C by any known method, e.g., heat-drying method such as hot-air drying and hot-roll drying, and infrared drying method.

The thickness of the anchor coat layer is preferably from 0.001 to 1 $\mu$m and more preferably from 0.05 to 0.5 $\mu$m from the viewpoints of flattening fine irregularities on the base film, enhancing denseness of the inorganic thin film layer, improving adhesion between the adjacent layers and curling resistance, and maintaining a good flexibility of the resultant base film.

[Inorganic Thin Film Layer]

In the gas-barrier laminate of the present invention, an inorganic thin film layer is formed on the surface of the anchor coat layer thus formed on the base film.

Examples of an inorganic material forming the inorganic thin film layer include silicon, aluminum, magnesium, zinc, tin, nickel, titanium, carbon hydride, and an oxide, a carbide, a nitride or a mixture of these materials. Among these inorganic materials, preferred is at least one material selected from the group consisting of silicon oxide, aluminum oxide, silicon nitride, aluminum nitride and diamond-like carbon (DLC). In particular, among them, the silicon oxide and aluminum oxide are more preferred in view of a capability of stably maintaining a good gas-barrier property.

The inorganic thin film layer may be formed by any suitable method such as a deposition method and a coating method. Among these methods, from the viewpoint of attaining a uniform thin film having a high gas-barrier property, the deposition method is preferred. The deposition method involves a physical vapor deposition (PVD) method such as vacuum deposition, ion plating and sputtering, and a chemical vapor deposition (CVD) method.

The thickness of the inorganic thin film layer is usually from about 0.1 to about 500 nm and preferably from 1 to 100 nm. When the thickness of the inorganic thin film layer lies within the above-specified range, the resultant laminate exhibits a sufficient gas-barrier property, and is excellent in transparency without occurrence of cracks or peeling in the inorganic thin film layer.

[Protective Resin Layer]

In the gas-barrier laminate of the present invention, if required, a protective resin layer may be formed on the surface of the thus formed inorganic thin film layer.

The thus formed protective resin layer serves for imparting a good barrier stability, a good bonding property, in particular, a good water-resistant bonding property, or a good marring resistance to the inorganic thin film layer.

The protective resin layer may be formed, for example, by applying a coating solution containing at least one resin selected from the group consisting of polyester-based resins, polyurethane-based resins, polyacrylic resins, isocyanate-based resins, oxazoline-based resins, carbodiimide-based resins, alcoholic hydroxyl group-containing resins and ionomer resins onto the surface of the inorganic thin film layer and then drying the resultant coating layer. Among these resins, from the above viewpoints, as the resin contained in the coating solution, preferred are those selected from the polyester-based resins, alcoholic hydroxyl group-containing resins and ionomer resins. The coating solution may be of either a solvent type containing an organic solvent, an aqueous solution type or an aqueous emulsion type.

The coating solution may also contain a silane coupling agent or an organotitanium compound for enhancing adhesion to the inorganic thin film layer, as well as various other known additives. Examples of the additives include antistatic agents, light-shielding agents, ultraviolet absorbers, plasticizers, fillers, colorants, stabilizers, defoaming agents, crosslinking agents, anti-blocking agents and antioxidants. These additives may be added to the coating solution within such a range that the effects of the present invention are not adversely affected.

Examples of the alcoholic hydroxyl group-containing resin include polyvinyl alcohol and an ethylene-vinyl alcohol copolymer.

The coating solution of the protective resin layer may be applied by any appropriate known coating methods. Examples of the coating methods include those methods using a reverse roll coater, a gravure coater, a rod coater, an air doctor coater, a sprayer or a brush. The coating solution applied may be dried at a temperature of from about 40 to about 180°C by any known method, e.g., heat-drying method such as hot-air drying and hot-roll drying, and infrared drying method.

The protective resin layer has, in addition to the above function of protecting the inorganic thin film layer, a function of enhancing adhesion of the inorganic thin film layer to the below-mentioned resin layer having a water vapor permeability of 100 $g/m^2$/24 h or less upon laminating the latter resin layer on the inorganic thin film layer.

The thickness of the protective resin layer is usually from about 0.05 to about 10 $\mu$m and preferably from 0.1 to 1 $\mu$m from the viewpoints of not only effectively exhibiting the above functions but also suppressing occurrence of blocking.

The gas-barrier laminate of the present invention is preferably heat-treated after forming the inorganic thin film layer when no protective resin layer is formed on the inorganic thin film layer, or after forming the protective resin layer when the protective resin layer is formed on the inorganic thin film layer, from the viewpoint of a good gas-barrier property of the resultant laminate. The heat-treating temperature is preferably not lower than 60°C but lower than a melting point of the base film, more preferably not lower than 70°C but lower than the melting point of the base film, and still more preferably from 70 to 160°C.

The heat-treating time varies depending upon the heat-treating temperature, and tends to be shortened as the heat-treating temperature increases. For example, the heat-treating time is from about 3 days to about 6 months at 60°C, from about 3 h to about 10 days at 80°C, from about 1 h to about 1 day at 120°C, and from about 3 to about 60 min at 150°C, although not particularly limited thereto.

Also, as the heat-treating method, there may be used, for example, a method of storing the gas-barrier laminate in an oven or constant-temperature chamber which is controlled to the temperature as required, a method of blowing a hot air to the gas-barrier laminate, a method of heating the gas-barrier laminate using an infrared heater, a method of irradiating light to the gas-barrier laminate using a lamp, a method of contacting the gas-barrier laminate with a hot roll or a hot plate to directly apply heat thereto, and a method of irradiating a microwave to the gas-barrier laminate. Upon the heat treatment, the gas-barrier laminate may be cut into a size capable of being easily handled, or the rolled gas-barrier laminate may be directly subjected to the heat treatment. Further, as long as the heat-treating temperature and time as required are attained, a heater may be incorporated into a part of apparatuses used for production of the gas-barrier laminate such as a coater and a slitter.

The gas-barrier laminate of the present invention has only one constitutional layer unit composed of the above base film, anchor coat layer and inorganic thin film layer, or may also have the two or more constitutional layer units. When the two or more constitutional layer units are provided in the gas-barrier laminate, the inorganic thin film layer of the second constitutional layer unit may be superimposed over that of the first constitutional layer unit, or the base film of the second constitutional layer unit may be superimposed over the inorganic thin film layer of the first constitutional layer unit.

[Resin Layer Having Water Vapor Permeability of 100 $g/m^2$/24 h or less]

Also, in the gas-barrier laminate of the present invention, at least one layer selected from the group consisting of a resin layer having a water vapor permeability of 100 g/m$^2$/24 h or less as measured at 40°C and 90% RH, and an additional inorganic thin film layer, is preferably formed directly or through the protective resin layer, on the inorganic thin film layer of the thus formed gas-barrier laminate. Examples of configuration of the gas-barrier laminate having such a layer include a laminate formed by laminating the resin layer having a water vapor permeability of 100 g/m$^2$/24 h or less either directly or through the protective resin layer, on the inorganic thin film layer of the constitutional layer unit produced by the above method, and a laminate formed by laminating an additional inorganic thin film layer either directly or through the protective resin layer on the inorganic thin film layer of the above constitutional layer unit, for example, by laminating the additional inorganic thin film layer on the side of the inorganic thin film layer of the above constitutional layer unit whose base film is replaced with the above resin layer having a water vapor permeability of 100 g/m$^2$/24 h or less, and a laminate formed by further laminating the two or more constitutional layer units on each other.

The additional inorganic thin film layer further laminated on the gas-barrier laminate may be the same inorganic thin film layer as described previously, and the thickness of the additional inorganic thin film layer may be the same as that of the previously described inorganic thin film layer.

The resin layer to be laminated on the above inorganic thin film layer or protective resin layer may be any resin layer that is transparent and has suitable mechanical properties as well as a water vapor permeability of 100 g/m$^2$/24 h or less. The method of forming the resin layer is not particularly limited as long as the resin layer can be suitably produced thereby. For example, the resin layer may be formed by laminating a plastic film made of a suitable resin or by applying a coating solution of the resin and then drying the resultant coating layer.

Examples of the plastic film used for forming the resin layer include films made of polyolefin-based resins such as polyethylene, ethylene-based copolymers, polypropylene and propylene-based copolymers; films made of vinyl chloride-based resins such as polyvinyl chloride and copolymers thereof; films made of vinylidene chloride-based resins such as vinylidene chloride-vinyl chloride copolymers; films made of polyester-based resins such as polyethylene terephthalate; films made of fluororesins such as polytetrafluoroethylene; films made of polyamide-based resins such as nylon 6, nylon 66, nylon 12, copolymer nylons and aromatic polyamides; films made of polyvinyl alcohol-based resins such as polyvinyl alcohol and ethylene-vinyl alcohol copolymers; and coated films obtained by coating these films with the other resin such as vinylidene chloride-based resins. These films may be in the form of either an unstretched film or a monoaxially or biaxially stretched film.

These plastic films may be laminated by known methods such as a dry lamination method using an urethane-based adhesive, an acrylic adhesive, a polyester-based adhesive, etc., and an extrusion lamination method.

On the other hand, when the resin layer is formed by applying the coating solution and then drying the resultant coating layer, examples of the coating solution include solutions or aqueous emulsions containing vinylidene chloride-based resins such as vinylidene chloride-vinyl chloride copolymers, polyester-based resins such as polyethylene terephthalate, fluororesins such as polytetrafluoroethylene, etc. Among these coating solutions, preferred are a latex of a vinylidene chloride-based resin, and a solution prepared by dissolving the vinylidene chloride resin in a solvent such as tetrahydrofuran.

The thickness of the resin layer is not particularly limited, and is usually from about 1 to about 400 μm, and preferably from 5 to 100 μm and more preferably from 5 to 50 μm from the viewpoints of a good barrier property and a good processability.

The thus produced gas-barrier laminate has a water vapor permeability of usually 0.2 g/m$^2$/24 h or less, preferably 0.1 g/m$^2$/24 h or less and more preferably 0.06 g/m$^2$/24 h or less as measured at 40°C and 90% RH.

In addition, when the gas-barrier laminate is subjected to 50 gelbo flex cycles in a gelbo flex test, the water vapor permeability of the thus treated gas-barrier laminate is usually 0.5 g/m$^2$/24 h or less, preferably 0.2 g/m$^2$/24 h or less and more preferably 0.1 g/m$^2$/24 h or less as measured under the same conditions as described above.

Meanwhile, the method for measuring the water vapor permeability and details of the gelbo flex test are described hereinafter.

[Heat-Sealable Resin Layer]

The gas-barrier laminate of the present invention is preferably provided with a heat-sealable resin layer that may be formed either directly or through a resin layer on an outer surface of the base film thereof. The heat-sealable resin layer to be provided on the outer surface of the base film may be formed directly on the surface of the base film by an extrusion lamination method using a resin having a good heat-sealing property such as, for example, low-density polyethylene, polypropylene, ethylene-vinyl acetate copolymers, ionomer resins, acrylic resins and biodegradable resins, or may be formed by a dry lamination method in which a film made of the above respective heat-sealable resins is dry-laminated on the surface of the base film layer through an urethane-based adhesive, an acrylic adhesive, a polyester-based adhesive, etc.

The thickness of the heat-sealable layer is not particularly limited, and is usually from about 5 to about 400 μm and preferably from 20 to 100 μm.

The thus produced gas-barrier laminate may also be subjected to heat treatment, if required, in order to enhance a gas-barrier property thereof. The heat-treating conditions and methods are the same as described in the previous heat treatment.

The whole thickness of the gas-barrier laminate of the present invention may be appropriately determined according to applications thereof, and is usually from about 10 to about 1000 $\mu$m and preferably from 30 to 500 $\mu$m from the viewpoints of good strength, flexibility and transparency of the resultant laminate and from the economical viewpoint. Further, the width and length of the gas-barrier laminate are not particularly limited, and may also be appropriately determined according to applications thereof.

The gas-barrier laminate of the present invention exhibits excellent gas-barrier property and gelbo flex resistance, and can be suitably used for packaging, for example, food, medicines or drugs, industrial product, etc., to prevent deterioration in quality thereof, sealing electroluminescent devices, or vacuum-sealing insulating plates having a porosity of 20% or more, or as a back sheet for solar cells.

[Process for Producing Gas-Barrier Laminate]

The present invention also relates to a process for producing a gas-barrier laminate which includes the steps of (1) forming a base film in the form of a biaxially stretched film having a variation in thickness of 3.5 $\mu$m or less and a crystallinity of 30% or more, from at least one compound selected from the group consisting of polyvinyl alcohol and an ethylene-vinyl alcohol copolymer; and (2) successively laminating an anchor coat layer and an inorganic thin film layer on one surface of the based film formed in the step (1) in this order, for example, a process for producing a gas-barrier laminate which includes the steps of (1) co-extruding an ethylene-vinyl alcohol copolymer and a polyamide and then subjecting the co-extruded product to biaxial stretching to form a base film in which the ethylene-vinyl alcohol copolymer has a crystallinity of 30% or more, and which has a variation in thickness of 3.5 $\mu$m or less; (2) successively laminating an anchor coat layer and an inorganic thin film layer on one surface of the based film formed in the step (1) in this order.

The requirements and constitutions of the above production processes are the same as described previously, and the respective additional layers and heat-treating conditions thereof, etc., are also the same as described previously.

EXAMPLES

The present invention is described in more detail below with reference to the following examples. However, these examples are only illustrative and not intended to limit the invention thereto.

Meanwhile, various properties of the gas-barrier laminates obtained in the respective Examples and Comparative Examples were evaluated by the following methods.

(1) Water Vapor Permeability (Moisture Permeability)

The water vapor permeability was measured by the following procedure according to the conditions prescribed in JIS Z 0222 "Method for Testing Water Vapor Permeability of Moisture-Proof Packaging Containers" and JIS Z 0208 " Method for Testing Water Vapor Permeability of Moisture-Proof Packaging Materials (Cup Method) ".

Two gas-barrier laminated films each having a water vapor-permeable area of 10.0 cm x 10.0 cm were formed into a bag sealed along four sides thereof enclosing about 20 g of anhydrous calcium chloride as a moisture absorbent. The thus prepared bag was placed in a thermo-hygrostat maintained at a temperature of 40°C and a relative humidity of 90%, and a mass (unit: 0.1 mg) of the bag was measured at time intervals of 48 h or longer until 14 days elapsed at which the increase in mass of the bag was kept substantially constant, and the water vapor permeability of the bag was calculated from the following formula. Meanwhile, the water vapor permeability values measured from 10th day to 14th day are shown in Tables 1 to 3.

$$\text{Water Vapor Permeability } (g/m^2/24\ h) = (m/s)/t$$

wherein m is an increase in mass (g) of the bag occurring during the last two time intervals for the measurement among the testing period; s is a water vapor-permeable area ($m^2$); and t represents the value expressed by [(time (h) taking during the last two time intervals for the measurement among the testing period)/24 (h)].

(2) Gelbo Flex Test

The film to be tested was cut into a size of 8 inch (20.3 cm) x 11 inch (27.9 cm) and conditioned at a temperature of 23°C and a relative humidity of 50% for 24 h or longer. One of the 11-inch (27.9 cm) sides of the thus conditioned film was affixed to an outer periphery of a disc-like stationary head of a gelbo flex tester available from Rigaku Kogyo Co., Ltd., and the other side of the film was affixed to an outer periphery of a disc-like movable head thereof such that the film was formed into a cylindrical shape having a length of 8 inch (20.3 cm) (both the heads were disposed in parallel with each other and spaced apart by a distance of 7 inch (17.8 cm) from each other).

The disc-like movable head was rotated 440° while approaching by 3.5 inch (8.9 cm) toward the stationary head, and then further approached by 2.5 inch (6.4 cm) toward the stationary head without being rotated. Thereafter, the above procedure was reversed to return the movable head to the original position. The procedure from initiation of approaching the movable head toward the stationary head to completion of returning the movable head to the original position is determined as one cycle. The procedure was continuously repeated for 50 cycles at a rate of 40 cycles per min.

(3) Variation in Thickness

Using a contact-type thickness meter "Militron" available from Seiko em Co., Ltd., the thickness of a film as a sample to be measured having a size of 10 cm in the width direction and 10 cm in the flow direction was measured at respective points located at intervals of 2 cm in the width direction and 2 cm in the flow direction to calculate a variation in thickness of the film from the maximum and minimum measured values.

(4) Crystallinity

(Crystallinity of PVA Film)

Using a differential scanning colorimeter available from Perkin Elmer Corp., the amount of heat of fusion (kJ/mol) of the film was measured, and the crystallinity (%) of the film was calculated from the thus measured value and by using, as the amount of heat of fusion of a crystal of a resin forming the film, the numeral value (kJ/mol) as described in "New Experimentation of Polymers", Vol. 8; "Properties of Polymers", Chapter 2, edited by Japan Institute of Polymers, according to the following formula:

$$\text{Crystallinity (\%)} = [(\text{Amount of Heat of Fusion of Film})/(\text{Amount of Heat of Fusion of Crystal})] \times 100.$$

(Crystallinity of EVOH Layer in Co-Extruded Film of ONY/EVOH/ONY)

The EVOH layer was isolated from the co-extruded film, and the crystallinity of the EVOH layer was determined by a density method using the relationship between an ethylene content, a density and a crystallinity thereof.

EXAMPLE 1

A polyvinyl alcohol resin having an average polymerization degree of 2600 and a degree of saponification of 99.5 mol% (hereinafter referred to merely as "PVA") was dissolved in water to obtain 48% hydrous PVA. The thus obtained hydrous PVA was charged into an extruder equipped with a gear pump and extruded through a T-die having a surface roughness of 0.1 s while controlling a variation in extrusion output within 2% to form a sheet. The resultant sheet was stretched at a temperature of 90°C and a stretch ratio of 2.0 in a longitudinal direction (MD) thereof and successively stretched at a temperature of 110°C and a stretch ratio of 2.0 in a lateral direction (TD) thereof, and then heat-treated at 200°C for 5 s to obtain a biaxially stretched PVA film having a thickness of 12 μm. Onto one surface of the thus obtained biaxially stretched film, a mixture composed of an isocyanate compound "COLONATE L" available from Nippon Polyurethane Kogyo Co., Ltd., and a saturated polyester "VIRON 300" (number-average molecular weight: 23000) available from Toyo Boseki Co., Ltd., at a mass ratio of 1:1, was applied and then dried to form an isocyanate-based anchor coat layer having a thickness of 100 nm on the film.

Next, using a vacuum deposition apparatus, SiO was vaporized under a vacuum of 1.33 mPa by a high-frequency heating method to form an inorganic thin film layer having a thickness of about 20 nm on the anchor coat layer, thereby producing a laminate as a constitutional layer unit.

An urethane-based adhesive made of a mixture composed of "AD900" and "CAT-RT85" both available from Toyo Morton Co., Ltd., at a mass ratio of 10:1.5 was applied onto a 12-μm thick biaxially stretched polyester film "DIAFOIL H100C" available from Mitsubishi Chemical Polyester Film Co., Ltd. (hereinafter referred to merely as a "PET" film), and then dried to form an adhesive resin layer having a thickness of about 3 $\mu$m on the PET film. The thus formed adhesive resin layer on the PET film was laminated on the side of the inorganic thin film layer of the above constitutional layer unit. Further, an additional adhesive resin layer was formed on the PVA film-side surface of the thus obtained laminate, and then a 50 $\mu$m-thick ethylene-vinyl acetate copolymer film "SB-7" available from Tama-Poly Co., Ltd., (hereinafter referred to merely as a "EVA film") was laminated on the additional adhesive resin layer, thereby producing a laminated film. The thus obtained laminated film was evaluated for the above properties. The results are shown in Table 1.

EXAMPLES 2 TO 20

Using the respective base films which had properties as shown in Table 1 and were made of materials as shown in Table 1, the constitutional layer units each having the anchor coat layer and inorganic thin film layer as shown in Table 1 were produced in the same manner as in Example 1. Meanwhile, in Examples 17 to 19, the protective resin layers having a thickness of 100 nm as shown in Table 1 were formed, and in Example 20, the resultant gas-barrier laminate was heat-treated at 80°C for 5 days.

The respective constitutional layer units were processed in the same manner as in Example 1 to obtain laminated films. The thus obtained laminated films were subjected to evaluation of properties thereof. The results are shown in Table 1. Meanwhile, the oxazoline-based, carbodiimide-based, acrylic and PVA-based anchor coat agents used in Examples 7, 8, 9 and 10, respectively, were as follows.

<Oxazoline-Based Anchor Coat Agent>

A flask equipped with a stirrer, a reflux condenser, a nitrogen inlet pipe, a thermometer and a dropping funnel was charged with 179 parts of deionized water and 1 part of 2,2'-azobis(2-amidinopropane) dihydrochloride as a polymerization initiator, and the contents of the flask were heated to 60°C while slowly flowing a nitrogen gas therethrough. Then, a previously prepared monomer mixture composed of 2 parts by mass of ethyl acrylate, 2 parts by mass of methyl methacrylate and 16 parts by mass of 2-isopropenyl-2-oxazoline was dropped into the flask through the dropping funnel over 1 h. Thereafter, the contents of the flask were reacted with each other under a nitrogen flow at 60°C for 10 h. After completion of the reaction, the resultant reaction solution was cooled to obtain an aqueous liquid of a 2-oxazoline group-containing resin having a solid concentration of 10% by mass.

<Carbodiimide-Based Anchor Coat Agent>

A flask equipped with a stirrer, a reflux condenser, a nitrogen inlet pipe, a thermometer and a dropping funnel was charged with 130 parts by mass of hexamethylene diisocyanate and 170 parts by mass of polyethylene glycol monomethyl ether (average molecular weight: 400), and the contents of the flask were stirred at 120°C for 1 h. In addition, 20 parts by mass of 4,4'-dicyclohexylmethane diisocyanate and 3 parts by mass of 3-methyl-1-phenyl-2-phospholene-1-oxide as a carbodimidation catalyst were charged into the flask, and the contents of the flask were further stirred at 185°C under a nitrogen flow for 5 h. After completion of the reaction, the resultant reaction solution was allowed to stand until being cooled to 60°C, thereby obtaining an aqueous liquid of a carbodiimide-based crosslinking agent having a solid concentration of 40% by mass.

<Acrylic Anchor Coat Agent>

A mixture composed of 40 parts by mass of ethyl acrylate, 30 parts by mass of methyl methacrylate, 20 parts by mass of methacrylic acid and 10 parts by mass of glycidyl methacrylate was subjected to solution polymerization in ethyl alcohol. After completion of the polymerization, the obtained reaction solution was heated while adding water thereto, to remove ethyl alcohol from the reaction solution. The pH of the resultant reaction solution was adjusted to 7.5 using an aqueous ammonia solution, thereby obtaining an aqueous coating material containing an aqueous acrylic resin.

<PVA-Based Anchor Coat Agent>

Polyvinyl alcohol (PVA) (saponification degree: 98.5 mol%; polymerization degree: 500) was introduced into ion-exchanged water at ordinary temperature while stirring, and dissolved therein at 95°C for 60 min, thereby obtaining an aqueous liquid of PVA having a solid concentration of 10% by mass.

The thickness of the respective anchor coat layers obtained from these anchor coat agents was 100 nm similarly to that of Example 1.

In addition, as the base films of Examples 4 to 6 and the protective resin layer of Example 17, the following EVOH film was used.

<EVOH>

A saponified product of an ethylene-vinyl acetate copolymer (ethylene content: 32 mol%; degree of saponification of vinyl acetate component: 99.5%; hereinafter referred to merely as "EVOH") was extruded at 220°C through a T-die fitted to an extruder to form a sheet. The obtained sheet was rapidly cooled on a cooling drum, and thermally fixed to obtain an amorphous film. The thus obtained film was stretched at a temperature of 90°C and a stretch ratio of 2.0 in a longitudinal direction (MD) thereof and successively stretched at a temperature of 100°C and a stretch ratio of 2.0 in a lateral direction (TD) thereof, and then heat-treated at 170°C for 5 s, thereby obtaining a 12 μm-thick biaxially stretched EVOH film.

Further, as the material for the protective resin layer of Example 18, there was used the following ionomer resin, and as the material for the protective resin layer of Example 19, there was used the following polyester resin.

<Ionomer Resin>

An ethylene-methacrylic acid copolymer (EMAA; methacrylic acid unit: 20% by mass; MFR: 300 g/10 min), sodium hydroxide and ion-exchanged water were mixed with each other while stirring at 95°C for 2 h, thereby preparing an aqueous liquid having a degree of neutralization of 80 mol% and a solid content of 20% by mass.

<Polyester Resin>

Twenty parts by mass of a polyester resin having a glass transition point of 55°C, a molecular weight of 8000 and a hydroxylation degree of 15 mg, 2 parts by mass of stearamide, 39 parts by mass of toluene and 39 parts by mass of MEK were mixed with a polyisocyanate "COLOMATE L" available from Nippon Polyurethane Co., Ltd., in an amount of 1.2 equivalents based on the hydroxylation equivalent, thereby preparing a coating solution for the protective resin layer.

COMPARATIVE EXAMPLES 1 TO 4

Using the respective base films which had properties shown in Table 1 and were made of materials shown in Table 1, the constitutional layer unit having no anchor coat layer and the inorganic thin film layer as shown in Table 1 (Comparative Example 1) and the constitutional layer units each having the anchor coat layer and inorganic thin film layer as shown in Table 1 (Comparative Examples 2 to 4) were produced in the same manner as in Example 1. Further, using the obtained respective gas-barrier constitutional layer units, the laminated films were produced and then evaluated for their properties in the same manner as in Example 1. The results are shown in Table 1.

TABLE 1-1

| | | Base film | | | |
|---|---|---|---|---|---|
| | | Material | Crystallinity (%) | Stretch ratio (MD x TD) | Variation in thickness (μm) |
| | Example 1 | PVA | 34 | 2 x 2 | 2.5 |
| | Example 2 | PVA | 41 | 3 x 3 | 1.2 |
| | Example 3 | PVA | 46 | 6 x 3 | 0.8 |
| | Example 4 | EVOH | 30 | 2 x 2 | 2.5 |
| | Example 5 | EVOH | 36 | 3 x 3 | 0.9 |
| | Example 6 | EVOH | 38 | 4 x 3 | 0.5 |
| | Example 7 | PVA | 41 | 3 x 3 | 1.2 |
| | Example 8 | PVA | 41 | 3 x 3 | 1.2 |
| | Example 9 | PVA | 41 | 3 x 3 | 1.2 |
| | Example 10 | PVA | 41 | 3 x 3 | 1.2 |
| | Example 11 | PVA | 41 | 3 x 3 | 1.2 |
| | Example 12 | PVA | 41 | 3 x 3 | 1.2 |
| | Example 13 | PVA | 41 | 3 x 3 | 1.2 |

(continued)

| | Base film | | | |
|---|---|---|---|---|
| | Material | Crystallinity (%) | Stretch ratio (MD x TD) | Variation in thickness ($\mu$m) |
| Example 14 | PVA | 41 | 3 x 3 | 1.2 |
| Example 15 | PVA | 41 | 3 x 3 | 1.2 |
| Example 16 | PVA | 41 | 3 x 3 | 1.2 |
| Example 17 | PVA | 41 | 3 x 3 | 1.2 |
| Example 18 | PVA | 41 | 3 x 4 | 2.2 |
| Example 19 | PVA | 41 | 3 x 4 | 2.2 |
| Example 20 | PVA | 41 | 3 x 3 | 1.2 |
| Comparative Example 1 | PVA | 41 | 3 x 3 | 1.2 |
| Comparative Example 2 | PVA | 28 | 1.5 x 1.5 | 2.5 |
| Comparative Example 3 | PVA | 41 | 3 x 3 | 4.6 |
| Comparative Example 4 | PYA | 25 | 3 x 3 | 2.3 |
| Note MD: Flow direction; TD: Width direction | | | | |

TABLE 1-2

| | Kind of anchor coat layer | Inorganic thin film layer | |
|---|---|---|---|
| | | Material | Thickness (nm) |
| Example 1 | Isocyanate-based | SiOx | 20 |
| Example 2 | Isocyanate-based | SiOx | 20 |
| Example 3 | Isocyanate-based | SiOx | 20 |
| Example 4 | Isocyanate-based | SiOx | 20 |
| Example 5 | Isocyanate-based | SiOx | 20 |
| Example 6 | Isocyanate-based | SiOx | 20 |
| Example 7 | Oxazoline-based | SiOx | 20 |
| Example 8 | Carbodiimide-based | SiOx | 20 |
| Example 9 | Acrylic | SiOx | 20 |
| Example 10 | PVA-based | SiOx | 20 |
| Example 11 | Isocyanate-based | SiOx | 5 |
| Example 12 | Isocyanate-based | SiOx | 50 |
| Example 13 | Isocyanate-based | SiOx | 100 |
| Example 14 | Isocyanate-based | $Si_xN_yO_z$ | 20 |
| Example 15 | Isocyanate-based | $Al_2O_3$ | 10 |
| Example 16 | Isocyanate-based | DLC | 20 |
| Example 17 | Isocyanate-based | SiOx | 20 |
| Example 18 | Isocyanate-based | SiOx | 20 |
| Example 19 | Isocyanate-based | SiOx | 20 |
| Example 20 | Isocyanate-based | SiOx | 20 |
| Comparative Example 1 | None | SiOx | 100 |

(continued)

| | Kind of anchor coat layer | Inorganic thin film layer | |
|---|---|---|---|
| | | Material | Thickness (nm) |
| Comparative Example 2 | Isocyanate-based | SiOx | 20 |
| Comparative Example 3 | Isocyanate-based | SiOx | 20 |
| Comparative Example 4 | Isocyanate-based | SiOx | 20 |
| Note DLC: Diamond-like carbon | | | |

TABLE 1-3

| | Protective resin layer | Heat treatment | Water vapor permeability of laminate (g/m²/24 h) | |
|---|---|---|---|---|
| | | | Before gelbo flex test | After 50 gelbo flex cycles |
| Example 1 | None | None | 0.07 | 0.12 |
| Example 2 | None | None | 0.03 | 0.09 |
| Example 3 | None | None | 0.01 | 0.07 |
| Example 4 | None | None | 0.10 | 0.18 |
| Example 5 | None | None | 0.05 | 0.12 |
| Example 6 | None | None | 0.02 | 0.10 |
| Example 7 | None | None | 0.02 | 0.06 |
| Example 8 | None | None | 0.03 | 0.08 |
| Example 9 | None | None | 0.04 | 0.12 |
| Example 10 | None | None | 0.05 | 0.13 |
| Example 11 | None | None | 0.10 | 0.18 |
| Example 12 | None | None | 0.02 | 0.08 |
| Example 13 | None | None | 0.01 | 0.20 |
| Example 14 | None | None | 0.01 | 0.05 |
| Example 15 | None | None | 0.09 | 0.14 |
| Example 16 | None | None | 0.01 | 0.08 |
| Example 17 | EVOH | None | 0.01 | 0.03 |
| Example 18 | Ionomer | None | 0.01 | 0.04 |
| Example 19 | Polyester | None | 0.01 | 0.05 |
| Example 20 | None | 80°C x 5 days | 0.01 | 0.06 |
| Comparative Example 1 | None | None | 0.35 | 1.23 |
| Comparative Example 2 | None | None | 0.67 | 0.83 |
| Comparative Example 3 | None | None | 0.24 | 0.32 |
| Comparative Example 4 | None | None | 0.38 | 0.47 |

EXAMPLE 21

Nylon 6 "NOVAMIDE 1022" available from Mitsubishi Kasei Co., Ltd., and the above EVOH used as the material for the base film in Example 4, were respectively charged into an extruder equipped with a gear pump, heat-melted therein at 240°C and extruded through a T-die having a surface roughness of 0.1 s while controlling a variation in extrusion output within 2%, and then introduced into a common die, to form a laminated film. The resultant laminated film was rapidly cooled on a cooling drum to obtain a laminated unstretched film having a layer structure composed of nylon 6 (150 $\mu$m)/EVOH (50 $\mu$m)/nylon 6 (150 $\mu$m). The thus obtained film was stretched at a temperature of 50°C and a stretch ratio of 2.0 in a longitudinal direction (MD) thereof and successively stretched at a temperature of 80°C and a stretch ratio of 2.0 in a lateral direction (TD) thereof (stretch ratio: 2.0 x 2.0), and then heat-treated at 200°C for 2 s to obtain a biaxially stretched co-extruded film having a whole thickness of 15 $\mu$m and a three-layer structure composed of nylon 6 (5 $\mu$m)/EVOH (5 $\mu$m)/nylon 6 (5 $\mu$m).
On one surface of the thus obtained biaxially stretched three-layer film, the anchor coat layer and the inorganic thin film layer were successively formed in the same manner as in Example 1, thereby obtaining a constitutional layer unit. Further, using the thus obtained constitutional layer unit, the laminated film was produced in the same manner as in Example 1. The resultant laminated film was subjected to the same evaluation as in Example 1. The results are shown in Table 2.

EXAMPLES 22 AND 23 AND COMPARATIVE EXAMPLE 5

Examples 22 and 23 and Comparative Example 5 were carried out in the same manner as in Example 21 except for changing the crystallinity, stretch ratio and variation in thickness as shown in Table 2, thereby producing respective laminated films. The thus obtained laminated films were subjected to the same evaluation as in Example 1. The results are shown in Table 2.

TABLE 2-1

| | Base film | | | |
|---|---|---|---|---|
| | Layer structure | Crystallinity (%) | Stretch ratio (MD x TD) | Variation in thickness ($\mu$m) |
| Example 21 | ONY(5 um)/EVOH(5 $\mu$m)/ONY(5 $\mu$m) | 30 | 2 x 2 | 2.2 |
| Example 22 | ONY(5 $\mu$m)/EVOH(5 $\mu$m)/ONY(5 $\mu$m) | 35 | 3 x 3 | 0.8 |
| Example 23 | ONY(5 $\mu$m)/EVOH(5 $\mu$m)/ONY(5 $\mu$m) | 37 | 6 x 3 | 0.6 |
| Comparative Example 5 | ONY(5 $\mu$m)/EVOH(5 $\mu$m)/ONY(5 $\mu$m) | 35 | 3 x 3 | 3.7 |
| Note MD: Flow direction; TD: Width direction | | | | |

TABLE 2-2

| | Kind of anchor coat layer | Inorganic thin film layer | |
|---|---|---|---|
| | | Material | Thickness (nm) |
| Example 21 | Isocyanate-based | SiOx | 20 |
| Example 22 | Isocyanate-based | SiOx | 20 |
| Example 23 | Isocyanate-based | SiOx | 20 |
| Comparative Example 5 | Isocyanate-based | SiOx | 20 |

TABLE 2-3

| | Protective resin layer | Heat treatment | Water vapor permeability of laminate (g/m$^2$/24 h) | |
| --- | --- | --- | --- | --- |
| | | | Before gelbo flex test | After 50 gelbo flex cycles |
| Example 21 | None | None | 0.21 | 0.34 |
| Example 22 | None | None | 0.06 | 0.12 |
| Example 23 | None | None | 0.03 | 0.09 |
| Comparative Examples 5 | None | None | 0.54 | 1.12 |

EXAMPLES 24 TO 30

Using the constitutional layer unit produced in Example 3 or Example 22, a 50 $\mu$m-thick EVA film (the same film as used in Example 1) was laminated on an outer surface of the base film thereof through an urethane-based adhesive (the same adhesive as used in Example 1). In addition, the gas-barrier laminates each having a layer structure as shown in Table 3 were respectively obtained by the lamination using an urethane-based adhesive (the same adhesive as used in Example 1), and evaluated for their properties. The results are shown in Table 3.
Meanwhile, in each of the laminates obtained by the lamination on the constitutional layer unit produced in Example 3 or Example 22, the SiOx layer had a thickness of 20 nm, and the anchor coat layer (AC) was made of an isocyanate-based compound (the same compound as used in Example 1) and had a thickness of 100 nm. Further, "PET" represents a 12 $\mu$m-thick biaxially stretched PET film (the same film as used in Example 1), and "ONY" represents a 15 $\mu$m-thick biaxially stretched nylon film "SANTONEAL SNR" available from Mitsubishi Plastics Inc.
TABLE 3

| | Layer structure of gas-barrier laminate | Water vapor permeability of laminate (g/m$^2$/24 h) | |
| --- | --- | --- | --- |
| | | Before gelbo flex test | After 50 gelbo flex cycles |
| Example 24 | EVA//[PVA/AC/SiOx]//[SiOx/AC/PET] | 0.005 | 0.03 |
| Example 25 | EVA//[PVA/AC/SiOx]//[SiOx/AC/ONY] | 0.006 | 0.04 |
| Example 26 | EVA//[PVA/AC/SiOx]//[SiOx/AC/PET] // [SiOx/AC/PET] | 0.0015 | 0.02 |
| Example 27 | EVA//[PVA/AC/SiOx]//[SiOx/AC/PET] // [SiOx/AC/ONY] | 0.0017 | 0.02 |
| Example 28 | EVA//[PVA/AC/SiOx]// [PVA/AC/SiOx] // [SiOx/AC/ONY] | 0.001 | 0.01 |
| Example 29 | EVA//[(ONY/EVOH/ONY)/AC/SiOx] // [SiOx/AC/PET] | 0.009 | 0.04 |
| Example 30 | EVA//[(ONY/EVOH/ONY)/AC/SiOx] // [SiOx/AC/PET]// [SiOx/AC/PET] | 0.002 | 0.02 |

INDUSTRIAL APPLICABILITY

The gas-barrier laminate of the present invention exhibits excellent gas-barrier property and gelbo flex resistance and can be therefore suitably used not only for packaging food, medicines or drugs, etc., but also for sealing electroluminescent devices or vacuum-sealing insulating plates. In addition, the gas-barrier laminate is also usable as a substrate for liquid crystal displays, solar cells, electromagnetic shields, touch panels, electroluminescent devices, etc., as well as a transparent conductive sheet used in color filters, etc.

**Claims**

1. A gas-barrier laminate comprising a base film containing at least one compound selected from the group consisting of polyvinyl alcohol and an ethylene-vinyl alcohol copolymer, and an anchor coat layer and an inorganic thin film layer successively formed on one surface of the base film in this order, wherein the base film is in the form of a biaxially stretched film having a variation in thickness of 3.5 μm or less and a crystallinity of 30% or more.

2. A gas-barrier laminate comprising a base film produced by co-extruding an ethylene-vinyl alcohol copolymer and a polyamide, and an anchor coat layer and an inorganic thin film layer successively formed on one surface of the base film in this order, wherein the base film is in the form of a biaxially stretched film having a variation in thickness of 3.5 μm or less, and the ethylene-vinyl alcohol copolymer contained in thee base film has a crystallinity of 30% or more.

3. The gas-barrier laminate according to claim 1 or 2, wherein the base film is in the form of a biaxially stretched film obtained by stretching an unstretched film from 2 to 6 times in a flow direction thereof and from 2 to 5 times in a width direction thereof.

4. The gas-barrier laminate according to any one of claims 1 to 3, wherein the base film has a thickness of from 5 to 500 μm.

5. The gas-barrier laminate according to any one of claims 1 to 4, wherein the base film has a variation in thickness of 2.5 μm or less.

6. The gas-barrier laminate according to any one of claims 1 to 5, wherein the anchor coat layer is made of at least one resin material selected from the group consisting of polyester-based resins, polyurethane-based resins, polyacrylic resins, isocyanate-based resins and oxazoline-based resins.

7. The gas-barrier laminate according to any one of claims 1 to 6, wherein the inorganic thin film layer has a thickness of from 0.1 to 500 nm.

8. The gas-barrier laminate according to any one of claims 1 to 7, further comprising a protective resin layer formed on a surface of the inorganic thin film layer.

9. The gas-barrier laminate according to any one of claims 1 to 8, further comprising at least one layer formed directly or through the protective resin layer on a surface of the inorganic thin film layer, said at least one layer being selected from the group consisting of a resin layer having a water vapor permeability of 100 g/m$^2$/24 h or less as measured at 40°C and 90% RH, and an additional inorganic thin film layer.

10. The gas-barrier laminate according to any one of claims 1 to 9, further comprising a heat-sealable resin layer formed directly or through a resin layer on the outer opposite surface of the base film.

11. The gas-barrier laminate according to any one of claims 1 to 10, wherein the gas-barrier laminate is heat-treated at a temperature of not lower than 60°C but lower than a melting point of the base film.

12. A process for producing a gas-barrier laminate, comprising the steps of:

    (1) forming a base film in the form of a biaxially stretched film having a variation in thickness of 3.5 μm or less and a crystallinity of 30% or more, from at least one compound selected from the group consisting of polyvinyl alcohol and an ethylene-vinyl alcohol copolymer; and
    (2) successively laminating an anchor coat layer and an inorganic thin film layer on one surface of the based film formed in the step (1) in this order.

13. A process for producing a gas-barrier laminate, comprising the steps of:

    (1) co-extruding an ethylene-vinyl alcohol copolymer and a polyamide and then subjecting the co-extruded film to biaxial stretching to form a base film in which the ethylene-vinyl alcohol copolymer has a crystallinity of 30% or more, and which has a variation in thickness of 3.5 μm or less; and
    (2) successively laminating an anchor coat layer and an inorganic thin film layer on one surface of the based film formed in the step (1) in this order.

**14.** A use of the gas-barrier laminate as defined in any one of claims 1 to 11 for packaging food.

**15.** A use of the gas-barrier laminate as defined in any one of claims 1 to 11 for sealing an electroluminescent device.

## INTERNATIONAL SEARCH REPORT

| International application No. |
| --- |
| PCT/JP2007/058180 |

A.   CLASSIFICATION OF SUBJECT MATTER
*B32B9/00*(2006.01)i, *B65D65/02*(2006.01)i, *H01L51/50*(2006.01)i, *H05B33/04*
(2006.01)i

According to International Patent Classification (IPC) or to both national classification and IPC

B.   FIELDS SEARCHED

Minimum documentation searched (classification system followed by classification symbols)
B32B1/00-43/00, B65D65/02, H01L51/50, H05B33/04

Documentation searched other than minimum documentation to the extent that such documents are included in the fields searched
Jitsuyo Shinan Koho          1922-1996   Jitsuyo Shinan Toroku Koho   1996-2007
Kokai Jitsuyo Shinan Koho    1971-2007   Toroku Jitsuyo Shinan Koho   1994-2007

Electronic data base consulted during the international search (name of data base and, where practicable, search terms used)

C.   DOCUMENTS CONSIDERED TO BE RELEVANT

| Category* | Citation of document, with indication, where appropriate, of the relevant passages | Relevant to claim No. |
| --- | --- | --- |
| Y | JP 1-184127 A  (Mitsubishi Monsanto Chemical Co.), 21 July, 1989 (21.07.89), Claims; page 1, right column, line 6; page 3, upper left column, line 10 to upper right column, line 2, lower left column, lines 3 to 18; page 4, upper left column, lines 9 to 11, upper left column, line 17 to upper right column, line 12; page 5, upper left column, lines 2 to 4 & US 5100720 A1          & EP 0311432 A2 | 1,3-12,14,15 |

| ☒ | Further documents are listed in the continuation of Box C. | ☐ | See patent family annex. |
| --- | --- | --- | --- |

| * | Special categories of cited documents: | "T" | later document published after the international filing date or priority date and not in conflict with the application but cited to understand the principle or theory underlying the invention |
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 05 July, 2007 (05.07.07) | 17 July, 2007 (17.07.07) |

| Name and mailing address of the ISA/ | Authorized officer |
| --- | --- |
| Japanese Patent Office | |
| Facsimile No. | Telephone No. |

Form PCT/ISA/210 (second sheet) (April 2005)

**INTERNATIONAL SEARCH REPORT**

| | International application No. |
|---|---|
| | PCT/JP2007/058180 |

C (Continuation).   DOCUMENTS CONSIDERED TO BE RELEVANT

| Category* | Citation of document, with indication, where appropriate, of the relevant passages | Relevant to claim No. |
|---|---|---|
| Y | JP 4-107138 A  (Mitsubishi Kasei Polytec Co.), 08 April, 1992 (08.04.92), Claims; page 1, right column, 2nd line from the bottom; page 3, lower left column, line 11 to lower right column, line 3; page 4, lower left column, lines 1 to 2, lower left column, 1st to 6th lines from the bottom; page 5, upper right column, lines 2 to 3 (Family: none) | 2-11,13-15 |
| Y | JP 2005-178087 A  (Nippon Zeon Co., Ltd.), 07 July, 2005 (07.07.05), Par. Nos. [0018], [0019] (Family: none) | 1-15 |
| Y | WO 1991/019604 A1  (Nippon Petrochemicals Co., Ltd.), 26 December, 1991 (26.12.91), Page 3, upper right column, lines 1 to 10 & US 5256491 A1        & EP 0487749 A1 | 1-15 |
| Y | JP 2003-89165 A  (Dainippon Printing Co., Ltd.), 25 March, 2003 (25.03.03), Par. Nos. [0018], [0019] (Family: none) | 1-15 |
| Y | JP 2-258251 A  (Mitsubishi Monsanto Chemical Co.), 19 October, 1990 (19.10.90), Field of industrial application & US 5112673 A1        & EP 0372489 A2 | 15 |

Form PCT/ISA/210 (continuation of second sheet) (April 2005)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 1184127 A
- JP 2258251 A
- JP 3086539 A
- JP 4107138 A

**Non-patent literature cited in the description**

- New Experimentation of Polymers. Properties of Polymers. Japan Institute of Polymers, vol. 8